# FASCICULE DE BREVET EUROPEEN

(11) **EP 3 381 072 B1**
(45) Date de publication et mention de la délivrance du brevet: **09.08.2023**
(21) Numéro de dépôt: 16800994.2
(22) Date de dépôt: 24.11.2016
(51) Int. Cl.: H01M 50/213

(54) **TRAPPE AMOVIBLE DE FERMETURE D'UN EMPLACEMENT ADAPTÉ POUR RECEVOIR AU MOINS UNE BATTERIE D'UN DISPOSITIF ÉLECTRONIQUE ET DISPOSITIF ÉLECTRONIQUE CORRESPONDANT**
ABNEHMBARE KLAPPE ZUM SCHLIESSEN EINER STELLE ZUR AUFNAHME VON MINDESTENS EINER BATTERIE EINER ELEKTRONISCHEN VORRICHTUNG UND ENTSPRECHENDE ELEKTRONISCHE VORRICHTUNG
REMOVABLE FLAP FOR CLOSING A LOCATION SUITABLE FOR RECEIVING AT LEAST ONE BATTERY OF AN ELECTRONIC DEVICE AND CORRESPONDING ELECTRONIC DEVICE

(30) Priorité: 27.11.2015 FR 1561511
(43) Date de publication de la demande: 03.10.2018
(73) Titulaire: Banks and Acquirers International Holding, 75015 Paris (FR)
(72) Inventeur: FROMENT, Marion, 26270 Loriol (FR)
(74) Mandataire: Vidon Brevets & Stratégie
(86) Numéro de dépôt international: PCT/EP2016/078733
(87) Numéro de publication internationale: WO 2017/089493

(56) Documents cités:
- GB-A- 2 315 936
- US-A1- 2004 080 916

## Description

### 1. Domaine

La technique proposée se rapporte à l'extraction de la batterie d'un dispositif électronique, et plus spécifiquement d'un terminal de paiement électronique.

### 2. Art Antérieur

Pour la plupart des dispositifs électroniques (voir par exemple US2004/080916 ou GB2315936 A) présentant une batterie extractible, il est nécessaire d'utiliser un outil (par exemple un tournevis ou encore une clé ou un stylo) afin d'extraire la batterie (par exemple pour la changer), une fois la trappe d'accès ouverte. En effet, dans la plupart des cas, la petite taille de la batterie et son emplacement rendent difficile l'extraction manuelle, sans outil, de la batterie. Or, l'utilisation d'un outil non adapté augmente le risque d'endommagement de la batterie, ou de l'emplacement de celle-ci, et à terme, empêche le maintien correct de la batterie dans son emplacement ou le fonctionnement correct de la batterie (par exemple par manque de contacts si la batterie n'est pas correctement maintenue dans son emplacement).

De plus, dans certains cas, l'utilisateur ayant besoin de changer la batterie peut ne pas avoir à sa disposition un outil lui permettant de l'extraire, retardant ainsi le changement de batterie. Cette situation peut se révéler problématique par exemple dans le cas d'un terminal de paiement électronique dont le commerçant a absolument besoin pour son activité.

Il existe donc un besoin de fournir une solution permettant de faciliter l'extraction d'une batterie d'un dispositif électronique, tout en assurant l'intégrité de la batterie et de son emplacement, ainsi que la rapidité et l'ergonomie d'extraction pour l'utilisateur.

### 3. Résumé

La technique proposée ne présente pas au moins certains des problèmes de l'art antérieur. Plus particulièrement, la technique proposée se rapporte à un trappe amovible de fermeture d'un emplacement adapté pour recevoir au moins une batterie d'un dispositif électronique, la trappe présentant, sur au moins un côté, au moins une première excroissance présentant une forme de patte adaptée pour libérer, via une première partie se situant dans un même plan que la trappe, au moins une zone correspondante de maintien de la batterie dans l'emplacement et adaptée pour faire levier et faire pivoter la batterie, via une deuxième partie se situant dans un plan sensiblement perpendiculaire à celui de la trappe.

Ainsi, l'invention propose une solution nouvelle et inventive pour faciliter l'extraction d'une batterie d'un dispositif électronique, par exemple un terminal de paiement électronique, en utilisant la trappe (amovible) de fermeture de l'emplacement de batterie comme un outil d'extraction de la batterie.

Pour ce faire, la trappe de fermeture de l'emplacement batterie est adaptée pour pouvoir d'une part libérer au moins une zone (dans l'emplacement de batterie) de maintien de la batterie dans son emplacement, et d'autre part pour extraire la batterie une fois la zone de maintien libérée.

Ainsi, la trappe présente au moins une excroissance en forme de « patte » ou crochet ou ergot, dont une première partie se situe dans le plan de la trappe, pour libérer la zone de maintien, et une deuxième partie se situe dans un plan sensiblement perpendiculaire à celui de la trappe, de façon à exercer une fonction de « pelle mécanique » permettant de faire levier sur la batterie pour la faire pivoter et ainsi l'extraire aisément de son emplacement.

En particulier, la deuxième partie de la première excroissance présente une forme externe recourbée adaptée à faire levier sur la batterie.

Ainsi, selon ce mode de réalisation, la première excroissance est recourbée à l'extérieur, de manière à pouvoir incliner la trappe pour faire levier sur la batterie et la faire pivoter pour l'extraire aisément de son emplacement.

Selon un aspect particulier, la trappe présente au moins une deuxième excroissance adaptée pour libérer au moins une deuxième zone correspondante de maintien de la batterie dans l'emplacement, la deuxième excroissance se situant sensiblement dans un même plan que la trappe.

Ainsi, selon ce mode de réalisation, la trappe de fermeture de l'emplacement batterie prévoit deux excroissances, afin de pouvoir libérer au moins deux zones (dans l'emplacement de batterie) de maintien de la batterie dans son emplacement.

Pour ce faire, la première excroissance, en forme de patte ou de crochet, permet à la fois de libérer une zone de maintien, via sa première partie sensiblement dans le même plan que la trappe, et de faire levier sur la batterie pour la faire pivoter, via sa deuxième partie dans un plan perpendiculaire à la trappe, pour l'extraire la batterie de l'emplacement (une fois la/les zones de maintien libérées), et la deuxième excroissance permet de libérer la deuxième zone de maintien de la batterie. Cette deuxième excroissance peut donc se situer sensiblement dans le même plan que celui de la trappe.

Ce mode de réalisation permet de s'adapter aux solutions techniques prévues pour répondre aux besoins de solidité et d'encombrement de conception de l'emplacement batterie d'un dispositif électronique, qui prévoient deux zones de maintien de la batterie, à libérer pour pouvoir extraire la batterie de son emplacement.

En particulier, la trappe peut prendre au moins trois positions :
- une position de fermeture dans laquelle la trappe ferme l'emplacement de réception de la batterie ;
- une position de libération de la batterie dans laquelle la ou les excroissances de la trappe libèrent la ou les zones de maintien ;
- une position d'extraction dans laquelle la première excroissance fait levier sur la batterie et fait pivoter la batterie hors de l'emplacement.

Ainsi, selon ce mode de réalisation, la trappe, qui sert classiquement de fermeture de l'emplacement batterie peut être utilisée pour extraire la batterie de son emplacement, via un mouvement en deux temps. En effet, dans un premier temps, la trappe sert à libérer la ou les zones de maintien de la batterie, via la ou les deux excroissances, puis, dans un deuxième temps, la première excroissance (en forme de patte ou de crochet constituée de deux parties sensiblement perpendiculaires) vient faire levier sur la batterie et la fait pivoter pour l'extraire aisément de l'emplacement.

Selon une caractéristique particulière, la ou les excroissances sont insérées dans un ou deux logements de l'emplacement de réception de la batterie, dans la position de fermeture, la ou les logements se situant à une extrémité opposée à la ou aux zones de maintien de la batterie, dans l'emplacement.

Ainsi, selon ce mode de réalisation, la ou les excroissances prévues pour extraire la batterie de son emplacement ne sont pas affleurantes lorsque la trappe est fermée mais sont protégées car insérées dans un ou deux logements de l'emplacement batterie prévus à cet effet.

De plus, ce ou ces deux logements des excroissances sont situés à l'opposé, dans l'emplacement batterie, des deux zones de maintien de la batterie. En effet, les excroissances ne pouvant pas à la fois servir à libérer des zones de maintien de la batterie et permettre la fermeture de la trappe, dans une même position de cette trappe, les excroissances de la trappe doivent être insérées, en position de fermeture, dans l'emplacement batterie à un autre endroit que celui où se situent les zones de maintien de la batterie.

Il en ressort que la trappe doit être retirée de sa position de fermeture, puis retournée pour pouvoir être utilisée comme outil d'extraction de la batterie.

Par exemple, la ou les zones de maintien de la batterie dans l'emplacement correspondent à un ou des ergots et, dans la position de libération, la ou les excroissances de la trappe exercent un appui respectivement sur chacun des ergots.

Ainsi, selon ce mode de réalisation, lorsque les zones de maintien de la batterie, dans l'emplacement, se présentent sous la forme d'un ou de deux ergots (pour des raisons d'encombrement dans l'emplacement), la ou les excroissances permettent d'appuyer sur ces ergots pour libérer la batterie, dans la position de libération.

L'invention concerne également un dispositif électronique comprenant une trappe amovible de fermeture d'un emplacement adapté pour recevoir au moins une batterie, telle que décrite précédemment.

En particulier, un tel dispositif électronique correspond à un terminal de paiement électronique présentant un emplacement adapté pour recevoir une batterie, l'emplacement présentant au moins deux ergots de maintien de la batterie.

### 4. Figures

D'autres caractéristiques et avantages apparaîtront plus clairement à la lecture de la description suivante d'un mode de réalisation particulier de la divulgation, donné à titre de simple exemple illustratif et non limitatif, et des dessins annexés, parmi lesquels :
- les figures 1a et 1b illustrent une trappe, respectivement en vue de dessous et de dessus, selon un premier mode de réalisation de l'invention ;
- les figures 2a et 2b illustrent une trappe, respectivement en vue de dessous et de dessus, selon un deuxième mode de réalisation de l'invention ;
- la figure 3 présente un exemple d'emplacement batterie, relativement au deuxième mode de réalisation de l'invention ;
- les figures 4a à 4c illustrent trois vues d'une trappe, respectivement au-dessus d'un emplacement de batterie d'un terminal de paiement électronique, en cours de fermeture de l'emplacement et en position de fermeture de l'emplacement, selon le deuxième mode de réalisation de l'invention ;
- les figures 5a et 5b illustrent deux vues de la trappe, respectivement en position de libération de la batterie et en position d'extraction de la batterie, selon le deuxième mode de réalisation de l'invention.

### 5. Description

### 5.1. Principe général

Le principe général de la technique proposée consiste à adapter la trappe de fermeture de l'emplacement batterie d'un dispositif électronique pour lui conférer une fonction d'outil extracteur de la batterie intrinsèque au dispositif.

Pour ce faire, la trappe modifiée présente au moins une excroissance, en forme de « patte » ou de « crochet », destinée à la fois à libérer au moins une zone de maintien de la batterie dans son emplacement et à « accrocher » la batterie, une fois libérée, pour pouvoir faire levier sur la batterie et ainsi la faire pivoter et l'extraire aisément de son emplacement.

Ainsi, un utilisateur souhaitant remplacer la batterie d'un dispositif électronique (par exemple un terminal de paiement électronique) peut se servir de la trappe de fermeture de l'emplacement batterie comme d'un outil d'extraction de la batterie, sans avoir besoin d'utiliser un autre outil distinct. De cette manière, la trappe adaptée, selon les différents modes de réalisation de l'invention, est spécifiquement prévue pour permettre l'extraction de la batterie sans endommager ni la batterie ni l'emplacement batterie, contrairement aux outils non adaptés utilisés couramment (un stylo, un tournevis, une clé ....) en l'absence de solution « intrinsèque » au dispositif électronique.

On notera que l'invention s'applique à tout dispositif électronique présentant un emplacement pour batterie extractible, fermée par une trappe, pouvant être adaptée selon les différents modes de réalisation de l'invention.

### 5.2. Description d'un premier mode de réalisation

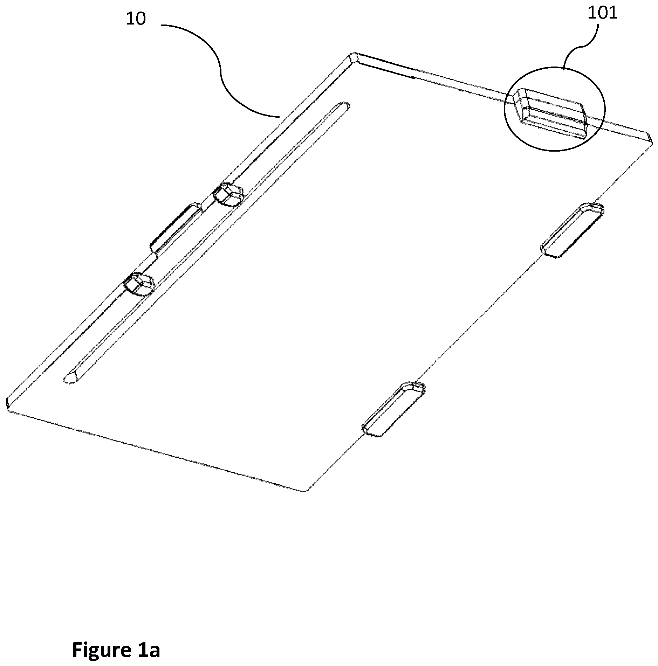

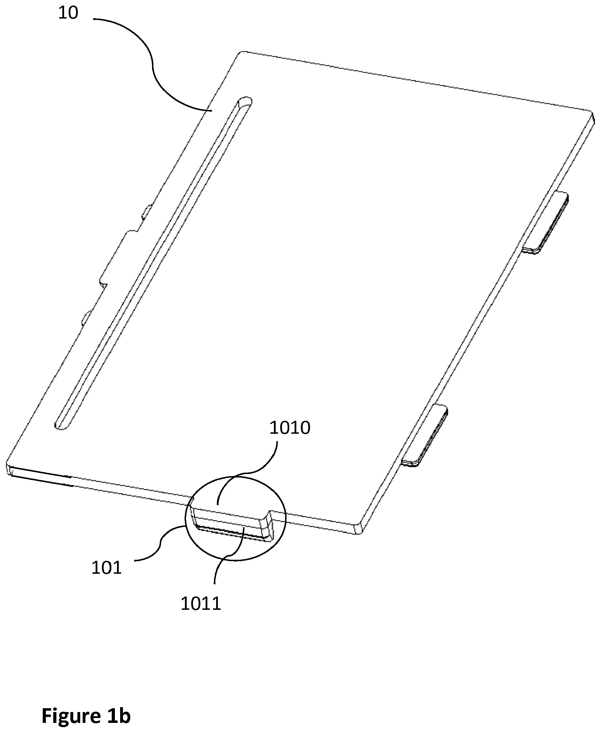

On décrit maintenant, en relation avec les figures 1a et 1b (respectivement en vue de dessus et de dessous de la trappe), un premier mode de réalisation de l'invention, dans lequel la trappe 10 de fermeture de l'emplacement batterie d'un dispositif électronique présente une excroissance 101, adaptée pour permettre l'extraction de la batterie d'un emplacement présentant une zone de maintien de cette batterie.

Comme illustrée en figure 1b, l'excroissance 101, ci-après notée première excroissance, présente une forme de patte, ou de crochet, en deux parties 1010 et 1011, permettant de conférer à la trappe les deux fonctions suivantes :
- une première fonction de libération de la zone de maintien de la batterie dans son emplacement, par appui sur cette zone de maintien de la première partie 1010 qui dépasse de la trappe sensiblement dans le même plan que celui de la trappe ;
- une deuxième fonction de « crochet » ou de « pelle mécanique », permettant d'accrocher la batterie une fois libérée de sa zone de maintien, via la deuxième partie 1011 se situant dans un plan sensiblement perpendiculaire à celui de la trappe.

Par exemple, la zone de maintien (dans l'emplacement batterie) se présente classiquement sous la forme d'un ergot en plastique permettant de retenir la batterie lorsqu'elle est insérée dans son emplacement, et qui nécessite donc d'être repoussé pour pouvoir libérer la batterie. Pour ce faire, la première partie 1010 de la première excroissance 101 de la trappe 10 présente par exemple une longueur suffisante pour faire appui sur cet ergot et ainsi libérer le maintien qu'il exerce sur la batterie. Pour des raisons de simplicité de fabrication, cette première partie se situe sensiblement dans le même plan que la trappe.

De plus, la deuxième partie 1011 de la première excroissance 101 de la trappe 10 se situe par exemple dans un plan sensiblement perpendiculaire à celui de la trappe, afin de pouvoir faire levier sur la batterie libérée et pouvoir la faire pivoter pour l'extraire de son emplacement. Là encore, cette deuxième partie 1011 présente une longueur suffisante pour pouvoir « accrocher » la batterie, cette longueur pouvant donc dépendre de l'épaisseur de la batterie. De plus, cette deuxième partie est recourbée à l'extérieur, de manière à ce que la trappe puisse être inclinée une fois la batterie libérée, pour faire levier sur la batterie et la faire pivoter.

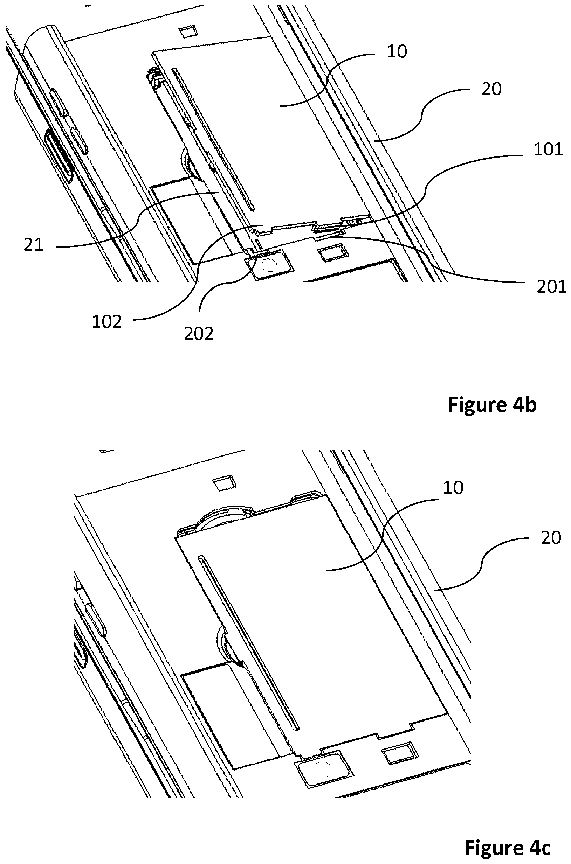

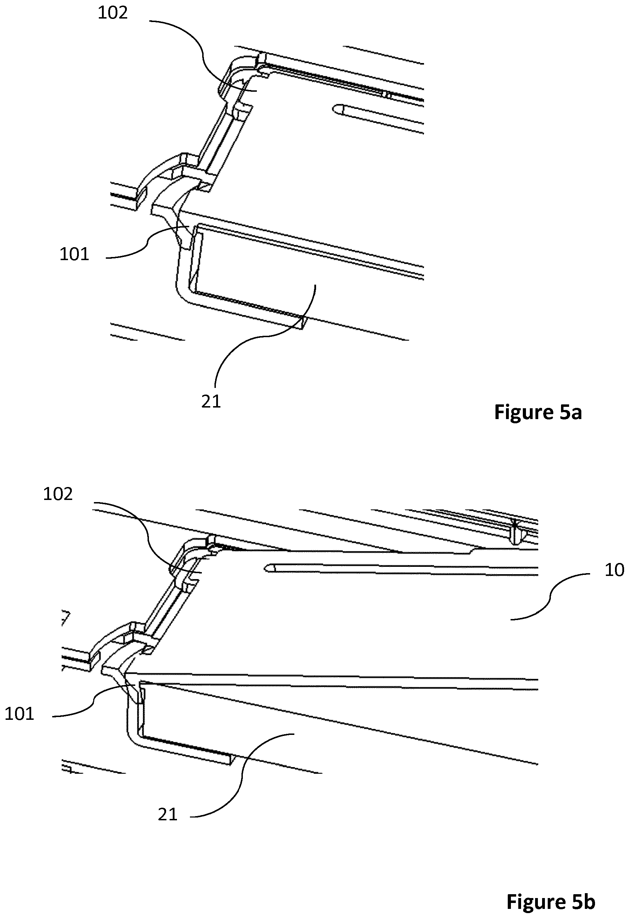

Comme décrit ci-après en relation avec les figures 4c, 5a et 5b, la trappe peut ainsi prendre au moins trois positions :
- une position de fermeture de l'emplacement batterie (figure 4c) ;
- une position de libération de la ou des zones de maintien de la batterie dans son emplacement, via l'appui de la ou des excroissances sur ces zones de maintien (figure 5a) ;
- une position d'extraction de la batterie de son emplacement, via l'utilisation de la première excroissance comme « crochet » pour faire levier sur la batterie et la faire pivoter (figure 5b).

Il est bien entendu que la zone de maintien de la batterie peut présenter une forme différente d'un ergot en plastique, dans la mesure où elle permet de maintenir la batterie dans son emplacement en mode d'utilisation, tout en permettant le retrait de la batterie (par exemple pour des raisons de maintenance ou de remplacement de cette dernière par une autre batterie préalablement rechargée pour une utilisation en continu du dispositif électronique).

### 5.3. Description d'un deuxième mode de réalisation

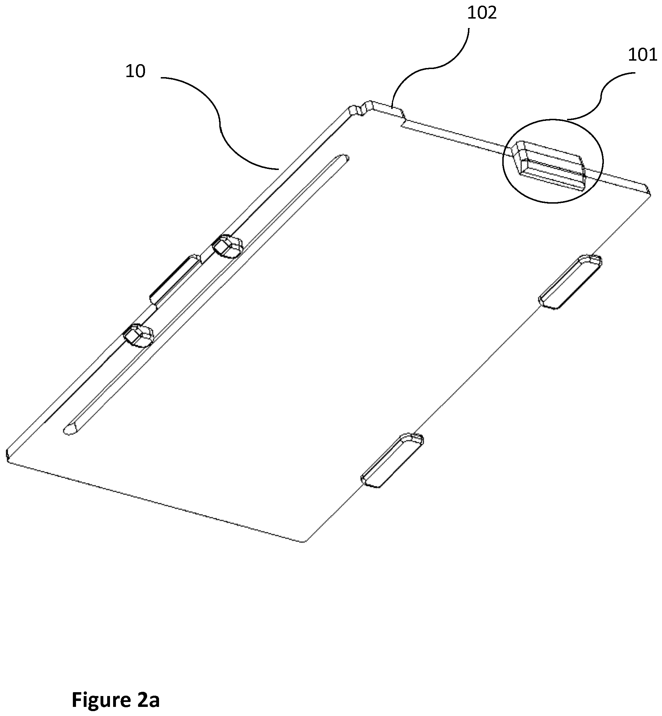

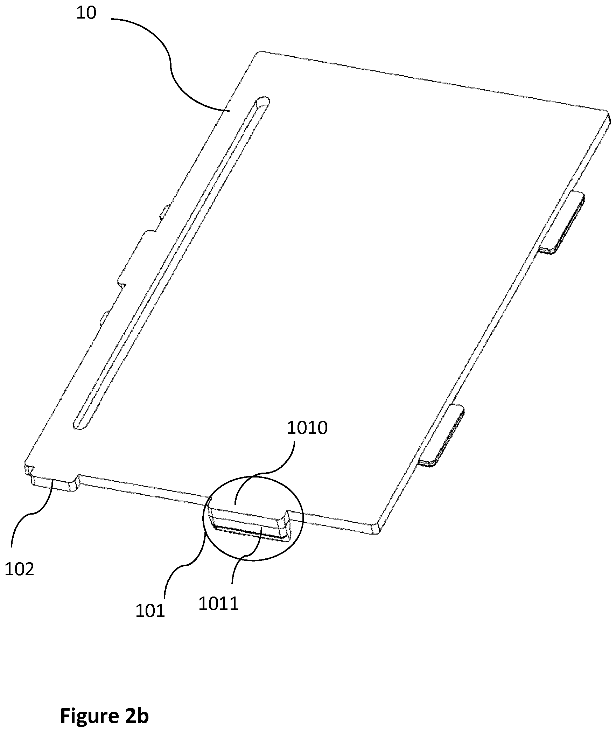

On décrit maintenant, en relation avec les figures 2a et 2b, un deuxième mode de réalisation de l'invention, dans lequel la trappe 10 de fermeture de l'emplacement batterie d'un dispositif électronique présente une deuxième excroissance 102, en plus de celle prévue et décrite au premier mode de réalisation.

Selon ce deuxième mode de réalisation, la trappe 10 (représentée en figures 2a et 2b respectivement en vue de dessus et de dessous) est donc adaptée pour permettre l'extraction de la batterie d'un emplacement présentant deux zones de maintien de cette batterie, via les deux excroissances 101 et 102.

La première excroissance 101, déjà décrite en relation avec le premier mode de réalisation, en forme de patte ou crochet, assurant à la fois la fonction de libération d'une zone de maintien et de levier pour faire pivoter la batterie, la deuxième excroissance 102 est adaptée à libérer la deuxième zone de maintien de la batterie dans son emplacement. Pour ce faire, la deuxième excroissance 102 se situe donc sensiblement dans le même plan que la trappe et permet de faire appui sur la deuxième zone de maintien (par exemple un ergot) et ainsi libérer la batterie.

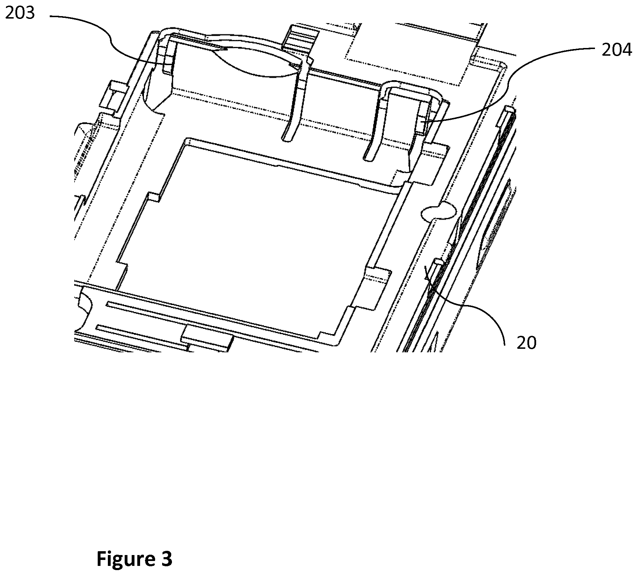

La figure 3 illustre un exemple d'emplacement batterie (sans la batterie) d'un dispositif électronique 20 présentant deux zones de maintien de la batterie, sous la forme d'ergots 203 et 204, destinés à maintenir la batterie, lorsque celle-ci est insérée dans l'emplacement, par appui des ergots sur la batterie.

Selon ce deuxième mode de réalisation, les excroissances 101 et 102 de la trappe 10 permettent donc de libérer ces deux ergots 203 et 204, en faisant appui dessus de sorte que la batterie ne soit plus maintenue par ces deux ergots.

Il est à noter que, selon la localisation des zones de maintien (par exemple des ergots) de la batterie dans l'emplacement, la localisation des excroissances sur la trappe est adaptée, de façon à ce que les excroissances se situent en regard des zones de maintien, en position de libération de la batterie.

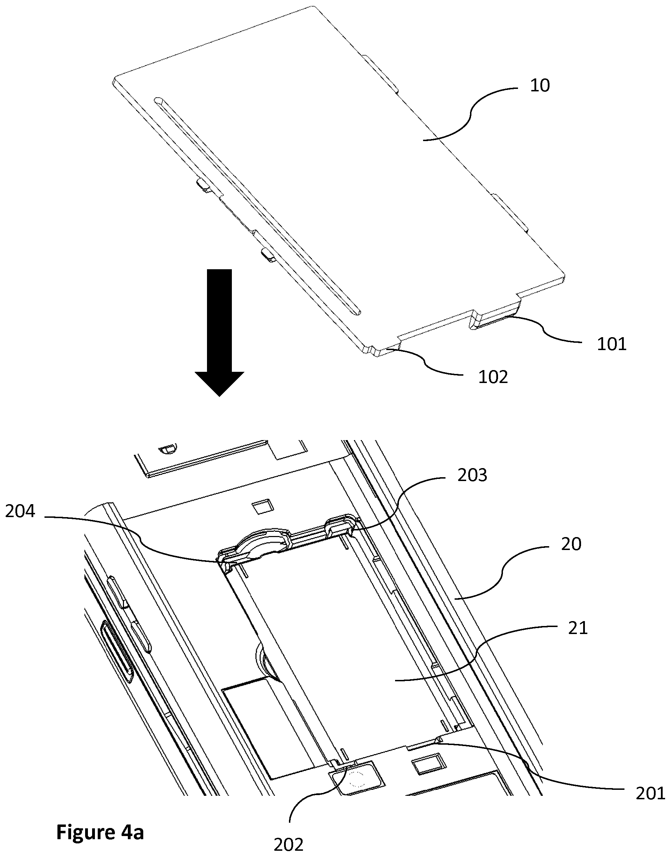

De plus, comme décrit plus en détails ci-dessous, il est prévu, dans l'emplacement batterie, à l'opposé des zones de maintien de la batterie (comme illustré en figures 4a à 4c décrites ci-après), deux logements de réception des deux excroissances de la trappe, lorsque celle-ci est en position de fermeture de l'emplacement batterie. En effet, ces deux excroissances ne doivent pas être mises en regard des zones de maintien de la batterie en position de fermeture de la trappe, de façon à ce qu'elles ne fassent pas appui sur ce zones, lorsque la trappe doit fermer l'emplacement dans lequel la batterie doit être maintenue. Il est donc prévu que la trappe 10 soit d'abord extraite de l'emplacement batterie, puis retournée, pour pouvoir servir d'outil d'extraction de la batterie.

### 5.4. Description d'un cas d'usage

On décrit maintenant, en relation avec les figures 4a à 4c et 5a à 5b, un exemple d'utilisation d'une trappe 10 selon le deuxième mode de réalisation de l'invention décrit ci-dessus.

On rappelle que, selon ce deuxième mode de réalisation, la trappe 10 présente au moins deux excroissances 101 et 102, destinées à permettre l'extraction de la batterie de son emplacement.

### a) Fermeture de l'emplacement batterie via la trappe

On présente d'abord, en relation avec les figures 4a à 4c, le mécanisme de fermeture de la trappe, permettant de fermer l'emplacement batterie via la trappe 10, une fois la batterie 21 insérée dans le dispositif électronique 20.

La partie haute de la figure 4a présente une vue de la trappe destinée à être positionnée au-dessus de la batterie, par un mouvement dont le sens est indiqué par la flèche, pour fermer l'emplacement batterie.

La partie basse de la figure 4a présente quant à elle une partie du dispositif électronique 20 avec la batterie 21 insérée dans son emplacement, lequel présente deux logements 201 et 202 destinés à recevoir respectivement les excroissances 101 et 102 de la trappe, en position de fermeture de celle-ci, ainsi que les deux zones de maintien de la batterie 203 et 204.

Par exemple, selon ce deuxième mode de réalisation, le premier logement 201 présente une première partie destinée à recevoir la première partie 1010 de la première excroissance 101 et une deuxième partie destinée à recevoir la deuxième partie 1011 de la première excroissance 101. Le deuxième logement 202 présente quant à lui une seule partie permettant de recevoir l'excroissance 102. Il est bien entendu que les logements présentent donc une forme adaptée à celles des excroissances, de manière à ce que la trappe puisse assurer une fermeture complète de l'emplacement batterie.
La figure 4b présente une vue de la trappe en cours de fermeture de l'emplacement batterie et recouvrant presque entièrement la batterie, les deux excroissances 101 et 102 n'étant cependant pas encore insérées dans leurs logements respectifs 201 et 202.
La figure 4c présente une vue de la trappe en position de fermeture de l'emplacement batterie, cette dernière n'étant donc plus visible car totalement occultée sous la trappe 10.

### b) Extraction de la batterie via la trappe

Les figures 5a et 5b illustrent le mécanisme d'extraction de la batterie par la trappe 10, selon ce deuxième mode de réalisation de l'invention, respectivement dans la position de libération des zones de maintien de la batterie et dans la position d'extraction de la batterie par pivotement de cette dernière.

Pour utiliser la trappe 10 comme outil d'extraction de la batterie, on rappelle ici que la trappe doit être ôtée de son emplacement et retournée de manière à ce que ses deux excroissances 101 et 102 se trouvent en regard des deux zones de maintien 203 et 204 (illustrées en figure 3 sous la forme d'ergots).

Selon la figure 5, la trappe est positionnée de manière à ce que les excroissances 101 et 102 fassent appui sur les zones de maintien, par exemple des ergots, afin de libérer la batterie 21.

Ensuite, une fois la batterie libérée de l'appui de ces ergots, la trappe est inclinée de manière à ce que l'excroissance 101, et plus particulièrement sa deuxième partie recourbée 1011, fasse levier sur la batterie 21 pour la faire pivoter, comme illustré en figure 5b, jusqu'à l'extraire de son emplacement (non illustré).

Ainsi, l'utilisateur peut extraire la batterie de son emplacement en utilisant la trappe de fermeture de cet emplacement, adaptée, selon les différents modes de réalisation de l'invention, pour offrir la fonctionnalité supplémentaire (et intrinsèque au dispositif) d'outil d'extraction de la batterie.

## Revendications

1. Dispositif électronique (20) présentant un emplacement de réception d'au moins une batterie (21) et au moins un ergot (204) de maintien de ladite batterie (21) dans ledit emplacement, ledit dispositif électronique comprenant une trappe (10) amovible de fermeture dudit emplacement, ladite trappe présentant, sur au moins un côté, au moins une première excroissance (101) présentant une forme de patte comprenant une première partie (1010), se situant dans un même plan que ladite trappe (10), et une deuxième partie (1011), se situant dans un plan sensiblement perpendiculaire à celui de ladite trappe (10), **caractérisé en ce que** ladite trappe (10) est configurée pour prendre au moins trois positions :
• une position de fermeture dans laquelle ladite au moins une première excroissance (101) est insérée dans au moins un logement (201, 202) dudit emplacement de sorte que ladite trappe (10) ferme ledit emplacement, ledit au moins un logement (201, 202) se situant à une extrémité opposée audit au moins un ergot (203, 204) de maintien de ladite batterie (21) ;
• une position de libération de ladite batterie (21) dans laquelle ladite première partie (1010) de ladite au moins une première excroissance (101) libère ledit au moins un ergot (203, 204) de maintien de ladite batterie (21) dans ledit emplacement ;
• une position d'extraction dans laquelle ladite deuxième partie (1011) de ladite première excroissance (101) fait levier sur ladite batterie (21) et fait pivoter ladite batterie (21) hors dudit emplacement.

2. Dispositif électronique selon la revendication 1, **caractérisé en ce que** ladite deuxième partie (1011) de ladite première excroissance (101) présente une forme externe recourbée configurée pour faire levier sur ladite batterie (21).

3. Dispositif électronique selon les revendications 1 ou 2, **caractérisé en ce que** ladite trappe présente au moins une deuxième excroissance (102) configurée pour libérer au moins une deuxième zone (203) correspondante de maintien de ladite batterie (21) dans ledit emplacement, ladite deuxième excroissance (102) se situant sensiblement dans un même plan que ladite trappe (10).

4. Dispositif électronique selon la revendication 1, **caractérisé en ce qu'**il correspond à un terminal de paiement électronique présentant un emplacement de réception d'une batterie, ledit emplacement présentant au moins deux ergots de maintien de ladite batterie.

## Patentansprüche

1. Elektronische Vorrichtung (20), die eine Stelle zur Aufnahme mindestens einer Batterie (21) und mindestens einen Haken (204) zum Halten der Batterie (21) in der Stelle aufweist, wobei die elektronische Vorrichtung eine abnehmbare Klappe (10) zum Schließen der Stelle umfasst, wobei die Klappe auf mindestens einer Seite mindestens einen ersten Vorsprung (101) aufweist, der eine Klauenform aufweist, umfassend einen ersten Teil (1010), der sich in einer selben Ebene wie die Klappe (10) befindet, und einen zweiten Teil (1011), der sich in einer Ebene im Wesentlichen senkrecht zu jener der Klappe (10) befindet, **dadurch gekennzeichnet, dass** die Klappe (10) eingerichtet ist, um mindestens drei Positionen einzunehmen:
- eine Schließposition, in der der mindestens eine Vorsprung (101) in mindestens eine Aufnahme (201, 202) der Stelle eingesetzt ist, so dass die Klappe (10) die Stelle schließt, wobei sich die mindestens eine Aufnahme (201, 202) an einem zu dem mindestens einen Haken (203, 204) zum Halten der Batterie (21) entgegengesetzten Ende befindet;
- eine Position zur Freigabe der Batterie (21), in der der erste Teil (1010) des mindestens einen Vorsprungs (101) den mindestens einen Haken (203, 204) zum Halten der Batterie (21) in der Stelle freigibt;
- eine Entnahmeposition, in der der zweite Teil (1011) des ersten Vorsprungs (101) auf die Batterie (21) als Hebel einwirkt und die Batterie (21) aus der Stelle schwenken lässt.

2. Elektronische Vorrichtung nach Anspruch 1, **dadurch gekennzeichnet, dass** der zweite Teil (1011) des ersten Vorsprungs (101) eine gekrümmte äußere Form aufweist, die eingerichtet ist, um auf die Batterie (21) als Hebel einzuwirken.

3. Elektronische Vorrichtung nach den Ansprüchen 1 oder 2, **dadurch gekennzeichnet, dass** die Klappe mindestens einen zweiten Vorsprung (102) aufweist, der eingerichtet ist, um mindestens eine zweite entsprechende Zone (203) zum Halen der Batterie (21) in der Stelle freizugeben, wobei sich der zweite Vorsprung (102) im Wesentlichen in einer selben Ebene wie die Klappe (10) befindet.

4. Elektronische Vorrichtung nach Anspruch 1, **dadurch gekennzeichnet, dass** sie einem elektronischen Zahlungsendgerät entspricht, das eine Stelle zur Aufnahme einer Batterie aufweist, wobei die Stelle mindestens zwei Haken zum Halten der Batterie aufweist.

## Claims

1. Electronic device (20) having a location for receiving at least one battery (21) and at least one lug (204) for holding said battery (21) in said location, said electronic device comprising a removable flap (10) for closing said location, said flap has, on at least one side, at least one first protrusion (101) in the form of a tab comprising a first part (1010), situated in a same plane as said flap (10), and a second part (1011), situated in a plane substantially perpendicular to that of said flap (10),
**characterized in that** said flap (10) is configured to take at least three positions:
• a closing position in which said at least one first protrusion (101) is inserted into at least one housing (201, 202) of said location so that said flap closes said location, said at least one housing (201, 202) being situated at an extremity opposite said at least one lug (203, 204) for holding said battery (21);
• a position of releasing said battery in which said first part (1010) of said first protrusion (101) releases said at least one lug (203, 204) for holding said battery (21) in said location;
• a position of removal in which said second part (1011) of said first protrusion (101) levers said battery (21) and makes pivot said battery (21) out of said location.

2. Electronic device according to claim 1, **characterised in that** said second part (1011) of said first protrusion (101) has a curved external shape configured to lever said battery (21).

3. Electronic device according to claim 1 or 2, **characterised in that** said flap has at least one second protrusion (102) configured to release at least one second corresponding area (203) for holding said battery (21) in said location, said second protrusion (102) being situated substantially in the same plane as said flap (10).

4. Electronic device according to claim 1, **characterised in that** it corresponds to an electronic payment terminal having a location for receiving of a battery, said location having at least two lugs for holding said battery.
